# EUROPEAN PATENT APPLICATION

(11) **EP 4 761 546 A1**
(43) Date of publication of application: **17.06.2026**
(21) Application number: 24852277.3
(22) Date of filing: 06.08.2024
(51) Int. Cl.: H10K 59/80, H10K 59/122, H10K 59/40, H10K 59/38, G06F 3/041

(54) **DISPLAY DEVICE**

(30) Priority: 08.08.2023 KR 20230103601; 28.02.2024 US 202418590063; 29.07.2024 CN 202411023037; 29.07.2024 CN 202421805521 U
(71) Applicant: Samsung Display Co., Ltd., Yongin-si, Gyeonggi-do 17113 (KR)
(72) Inventor: LEE, Jinhyeong, Yongin-si, Gyeonggi-do 17113 (KR); KIM, Su Jeong, Yongin-si, Gyeonggi-do 17113 (KR); KIM, Wooyoung, Yongin-si, Gyeonggi-do 17113 (KR); LEE, Eunbee, Yongin-si, Gyeonggi-do 17113 (KR); LEE, Jungwoo, Yongin-si, Gyeonggi-do 17113 (KR)
(74) Representative: Dr. Weitzel & Partner
(86) International application number: PCT/KR2024/011577
(87) International publication number: WO 2025/033923

(57) **Abstract**

A display device according to an embodiment includes a substrate, a plurality of first electrodes positioned on the substrate, a pixel defining layer having a plurality of pixel openings overlapping each of the plurality of first electrodes, a plurality of light emitting layers respectively positioned within the plurality of pixel openings of the pixel defining layer, a second electrode positioned on the plurality of light emitting layers and the pixel defining layer, an encapsulation layer positioned on the second electrode, a lower sensing electrode part positioned on the encapsulation layer, a first sensing insulating layer positioned on the lower sensing electrode part, an upper sensing electrode part and a reflective layer positioned on the first sensing insulating layer, a first light blocking layer and a second light blocking layer positioned on the upper sensing electrode part, and a color filter positioned on the first light blocking layer and the second light blocking layer, wherein a lower surface of the reflective layer has a curved shape, and the second light blocking layer is randomly disposed on a plane.

## Description

### [Field of the Invention]

The present disclosure relates to a display device, and more particularly, to a display device in which external light reflectance is effectively reduced.

### [Description of the Related Art]

The display device is a device that displays a screen, and includes a liquid crystal display (LCD), an organic light emitting diode (OLED), and the like.

Such display devices are used in various electronic devices such as mobile phones, navigation devices, digital cameras, electronic books, portable game consoles, and various terminals.

### [DETAILED DESCRIPTION OF THE INVENTION]

### [TECHNICAL PROBLEM]

Embodiments are intended to provide a display device capable of improving display quality by reducing external light reflection.

### [TECHNICAL SOLUTION]

A display device according to an embodiment includes a substrate, a first electrode positioned on the substrate, a pixel defining layer having a pixel opening overlapping the first electrode, a light emitting layer positioned within the pixel opening, a second electrode positioned on the light emitting layer and the pixel defining layer, an encapsulation layer positioned on the second electrode, a lower sensing electrode part positioned on the encapsulation layer, a first sensing insulating layer positioned on the lower sensing electrode part, an upper sensing electrode part and a reflective layer positioned on the first sensing insulating layer, and a first light blocking layer and a second light blocking layer disposed on the first sensing insulating layer, wherein at least a portion of a lower surface of the reflective layer has an inclined surface.

The second light blocking layer may include a second-1 sub-light blocking layer overlapping the first pixel, a second-2 sub-light blocking layer overlapping the second pixel, and a second-3 sub-light blocking layer overlapping the third pixel.

The display device includes a plurality of second-1 sub-light blocking layers, the second-1 sub-light blocking layer has an elliptical shape, and has a first major axis, and a first angle between the first major axis and a first direction may have at least 2 or more values.

The first major axis of the plurality of second-1 sub-light blocking layers may be randomly disposed.

A plurality of the first major axes may be arranged at equal intervals.

The display device includes a plurality of second-2 sub-light blocking layers, the second-2 sub-light blocking layer has an elliptical shape and has a second major axis, and a second angle between the second major axis and the first direction may have at least 2 or more values.

The plurality of second major axes may be arranged at equal intervals or may be randomly arranged.

The display device includes a plurality of second-3 sub-light blocking layers, the second-2 sub-light blocking layer has an elliptical shape and has a third major axis, and a third angle between the third major axis and the first direction may have at least 2 or more values.

The plurality of third major axes may be arranged at equal intervals or may be randomly arranged.

The major axis of the second-1 sub-light blocking layer, the major axis of the second-2 sub-light blocking layer, and the major axis of the second-3 sub-light blocking layer may be disposed in different directions.

The display device may further include a color filter positioned on the first light blocking layer and the second light blocking layer.

Areas of the second-1 sub-light blocking layer, the second-2 sub-light blocking layer, and the second-3 sub-light blocking layer may be different from each other.

A planar shape of the second light blocking layer may be a triangle, a quadrangle, or a pentagon.

The second light blocking layer may overlap the emission layer, and the first light blocking layer may overlap the pixel defining layer.

A display device according to an embodiment includes a substrate, a plurality of first electrodes positioned on the substrate, a pixel defining layer having a plurality of pixel openings overlapping each of the plurality of first electrodes, a plurality of light emitting layers respectively positioned within the plurality of pixel openings of the pixel defining layer, a second electrode positioned on the plurality of light emitting layers and the pixel defining layer, an encapsulation layer positioned on the second electrode, a lower sensing electrode part positioned on the encapsulation layer, a first sensing insulating layer positioned on the lower sensing electrode part, an upper sensing electrode part positioned on the first sensing insulating layer, a plurality of reflective layers disposed on the first sensing insulating layer and overlapping the plurality of pixel openings, respectively, and a plurality of light blocking layers positioned on the plurality of reflective layers, wherein the plurality of light blocking layers have at least two different planar shapes.

The second light blocking layer may include a second-1 sub-light blocking layer overlapping the first pixel, a second-2 sub-light blocking layer overlapping the second pixel, and a second-3 sub-light blocking layer overlapping the third pixel.

The second-1 sub-light blocking layer may have a shape obtained by rotating the second-2 sub-light blocking layer in a clockwise direction on a plane.

Planar areas of the second-1 sub-light blocking layer and the second-2 sub-light blocking layer may be different.

The first sensing insulating layer may include a first opening exposing the lower sensing electrode part and a plurality of second openings respectively overlapping the plurality of pixel openings.

The upper sensing electrode part may be formed in the first opening, and the plurality of reflective layers may be formed in the plurality of second openings.

### [ADVANTAGEOUS EFFECTS OF THE INVENTION]

According to embodiments, a display device capable of improving display quality by reducing external light reflection may be provided.

### [BRIEF DESCRIPTION OF THE DRAWINGS]

FIG. 1 is a schematic perspective view illustrating a use state of a display device according to an embodiment.
FIG. 2 is an exploded perspective view of a display device according to an embodiment.
FIG. 3 is a block diagram of a display device according to an embodiment.
FIG. 4 is a schematic plan view of a sensing electrode in a display panel according to an embodiment.
FIG. 5 is a cross-sectional view illustrating a portion of a display area in a display panel according to an embodiment.
FIG. 6 is a schematic plan view illustrating a plurality of pixels according to an embodiment.
FIG. 7 is a plan view showing a part of FIG. 6.
FIG. 8, FIG. 9, FIG. 10, and FIG. 11 are schematic plan views illustrating a plurality of pixels according to an embodiment.

### [DETAILED DESCRIPTION OF THE EMBODIMENTS]

Hereinafter, various embodiments will be described in detail with reference to the accompanying drawings so that those skilled in the art can easily carry out the present invention.

This invention may be embodied in many different forms, and is not limited to the embodiments set forth herein.

In order to clearly describe the present invention, parts irrelevant to the description are omitted, and the same reference numerals are assigned to the same or similar components throughout the specification.

In addition, since the size and thickness of each component shown in the drawings are arbitrarily shown for convenience of explanation, the present invention is not necessarily limited to that which is shown.

In the drawings, the thickness is shown enlarged to clearly express the various layers and regions.

And in the drawings, for convenience of explanation, the thicknesses of some layers and regions are exaggerated.

In addition, when a part such as a layer, film, region, or plate is said to be "above" or "on" another part, this includes not only the case where it is "directly on" the other part, but also the case where another part exists in the middle thereof.

Conversely, when a part is said to be "directly on" another part, it means that there is no other part in between.

In addition, being "above" or "on" a reference part means being positioned above or below the reference part, and does not necessarily mean being positioned "above" or "on" it in the opposite direction of gravity.

In addition, throughout the specification, when a certain component is said to "include," it means that it may further include other components without excluding other components unless otherwise stated.

Also, throughout the specification, when reference is made to a "planar image," it means when the target part is viewed from above, and when reference is made to a "cross-sectional image," it means when the cross-section of the target part cut vertically is viewed from the side.

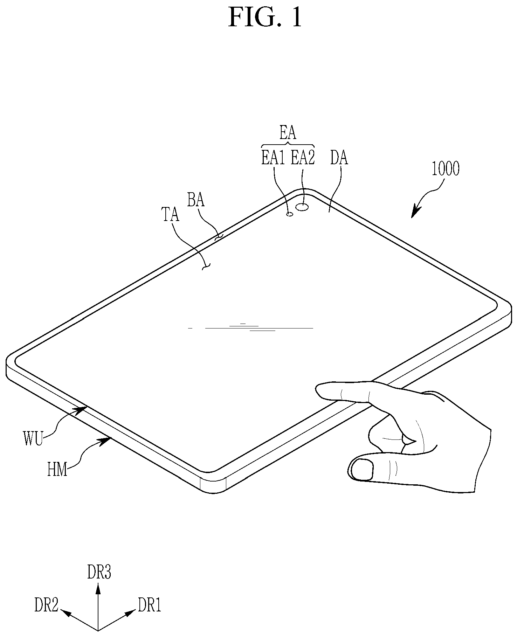

Hereinafter, a schematic structure of the display device will be described with reference to FIG. 1 to FIG. 3.

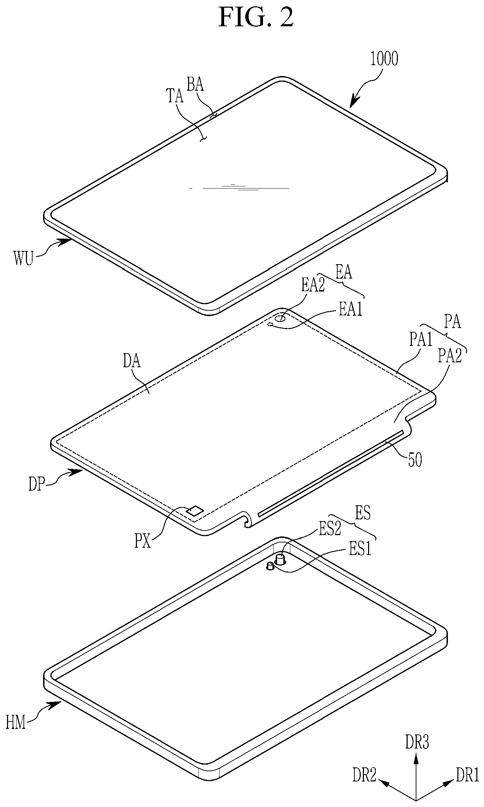

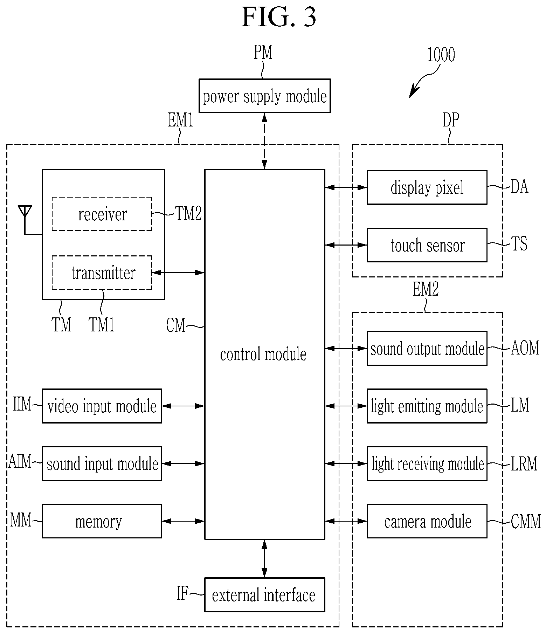

FIG. 1 is a schematic perspective view illustrating a use state of a display device according to an embodiment, FIG. 2 is an exploded perspective view of the display device according to an embodiment, and FIG. 3 is a block diagram of the display device according to an embodiment.

Referring to FIG. 1, the display device 1000 according to an embodiment is a device for displaying videos or still images, and may be used as a display screen for various products such as mobile phones, smart phones, tablet personal computers, mobile communication terminals, electronic notebooks, e-books, portable multimedia players (PMP), navigation, ultra- mobile personal computers (UMPC), as well as televisions, notebooks, monitors, billboards, and the Internet of Things (IOT).

Furthermore, the display device 1000 according to an embodiment may be used in wearable devices such as smart watches, watch phones, glasses-type displays, and head-mounted displays (HMD).

Also, the display device 1000 according to an embodiment may be used as a car's instrument panel, a center information display (CID) placed on the car's center fascia or dashboard, a room mirror display replacing the car's side mirror, and a display placed on the back of the front seat for rear seat entertainment in a car.

FIG. 1 shows that the display device 1000 is used as a tablet PC for convenience of description.

The display device 1000 may display an image in a third direction DR3 on a display surface parallel to each of the first and second directions DR1 and DR2.

The display surface on which the image is displayed may correspond to the front surface of the display device 1000 and may correspond to the front surface of the cover window WU.

The image may include a still image as well as a dynamic image.

In this embodiment, the front (or upper surface) and rear surface (or lower surface) of each member are defined based on the direction in which the image is displayed.

The front and back surfaces oppose each other in the third direction DR3, and the normal directions of each front and back surface can be parallel to the third direction DR3.

The deviation distance between the front and back surfaces may correspond to the thickness of the display panel in the third direction DR3.

The display device 1000 according to an embodiment may detect a user's input (refer to a hand in FIG. 1) applied from the outside.

The user's input may include various types of external inputs, such as a part of the user's body, light, heat, or pressure.

In an embodiment, the user's input is shown as the user's hand being applied in the foreground.

However, the present invention is not limited thereto.

User input may be provided in various forms.

Also, the display device 1000 may detect a user's input applied to the side or rear surface of the display device 1000 according to the structure of the display device 1000.

Referring to FIG. 1 and FIG. 2, the display device 1000 may include a cover window WU, a housing HM, a display panel DP, and an optical element ES.

In an embodiment, the cover window WU and the housing HM may be combined to form the exterior of the display device 1000.

The cover window WU may include an insulating panel.

For example, the cover window WU may be made of glass, plastic, or a combination thereof.

The front surface of the cover window WU may define the front surface of the display device 1000.

The transmission area TA may be an optically transparent area.

For example, the transmission area TA may have a visible light transmittance of about 90% or more.

The blocking area BA may define the shape of the transmission area TA.

The blocking area BA may be adjacent to the transmission area TA and may surround the transmission area TA.

The blocking area BA may have relatively low light transmittance compared to the transmission area TA.

The blocking area BA may include an opaque material that blocks light.

The blocking area BA may have a predetermined color.

The blocking area BA may be defined by a bezel layer provided separately from the transparent substrate defining the transmission area TA, or may be defined by an ink layer inserted into or colored in the transparent substrate.

The display panel DP may include a front surface including a display area DA and a non-display area PA.

The display area DA may be an area where pixels operate according to electrical signals to emit light.

The non-display area PA of the display panel DP may include the driving unit 50.

In an embodiment, the display area DA may be an area including pixels and displaying an image, and may also be an area where a touch sensor is positioned above the pixel in the third direction DR3 to sense an external input.

The transmission area TA of the cover window WU may at least partially overlap the display area DA of the display panel DP.

For example, the transmission area TA may overlap the entire surface of the display area DA or may overlap at least a portion of the display area DA.

Accordingly, the user may view the image through the transmission area TA or provide an external input based on the image.

However, the present invention is not limited thereto.

For example, within the display area DA, an area where an image is displayed and an area where an external input is sensed may be separated from each other.

The non-display area PA of the display panel DP may at least partially overlap the blocking area BA of the cover window WU.

The non-display area PA may be an area covered by the blocking area BA.

The non-display area PA is adjacent to the display area DA and may surround the display area DA.

An image is not displayed in the non-display area PA, and a driving circuit or a driving wire for driving the display area DA may be disposed.

The non-display area PA may include a first peripheral area PA1 located outside the display area DA and a second peripheral area PA2 including the driving unit 50, connection wires, and a bending area.

In the embodiment of FIG. 2, the first peripheral area PA1 is located on the three sides of the display area DA, and the second peripheral area PA2 is located on the other side of the display area DA.

In the embodiment, the display panel DP may be assembled in a flat state with the display area DA and the non-display area PA facing the cover window WU.

However, the present invention is not limited thereto.

A part of the non-display area PA of the display panel DP may be bent.

At this time, some of the non-display area PA faces the rear surface of the display device 1000, so that the blocking area BA visible on the front of the display device 1000 can be reduced. In FIG. 2, the second peripheral area (PA2) may be bent and positioned on the rear surface of the display area DA, and then assembled.

Also, the display panel DP may include a component area EA, and specifically, a first component area EA1 and a second component area EA2.

The first component area EA1 and the second component area EA2 may be at least partially surrounded by the display area DA.

The first component area EA1 and the second component area EA2 are illustrated as being spaced apart from each other, but are not limited thereto and may be connected at least in part.

The first component area EA1 and the second component area EA2 may be areas in which components using infrared rays, visible rays, or sound are disposed below the first component area EA1 and the second component area EA2.

In the display area DA, a plurality of light emitting diodes and a plurality of pixel circuit units generating and transmitting a light emitting current are formed in each of the plurality of light emitting diodes.

Here, one light emitting diode and one pixel circuit part are referred to as a pixel PX.

In the display area DA, one pixel circuit unit and one light emitting diode are formed on a one-to-one basis.

The first component area EA1 may include a transmission part through which light or/and sound may pass and a display portion including a plurality of pixels.

The transmission part is located between adjacent pixels, and is composed of a layer that allows light and/or sound to penetrate.

The transmission part may be positioned between adjacent pixels, and depending on embodiments, a layer that does not transmit light, such as a light blocking layer, may overlap the first component area EA1.

The number of pixels per unit area (hereinafter referred to as resolution) of the pixels (hereinafter referred to as normal pixels) included in the display area DA and the pixels included in the first component area EA1 (hereinafter referred to as first component pixels) may be the same.

The second component area EA2 includes an area made of a transparent layer to allow light to pass therethrough (hereinafter referred to as a light transmitting area) a layer-for example, a pixel defining layer and/or a light blocking layer -may include an opening overlapping a position corresponding to the second component area EA2 so as not to block light.

The number of pixels per unit area of the pixels (hereinafter referred to as second component pixels) included in the second component area EA2 may be smaller than the number of pixels per unit area of normal pixels included in the display area DA.

As a result, the resolution of the second component pixels may be lower than that of the normal pixels.

Referring to FIGS. 1 and 2 and FIG. 3, the display panel DP may include a display area DA including display pixels and a touch sensor TS.

The display panel DP may be visually recognized by a user from the outside through the transmission area TA, including pixels that are components for generating images.

Also, the touch sensor TS may be positioned above the pixels and may detect an external input applied from the outside.

The touch sensor TS may detect an external input provided to the cover window WU.

Again, referring to FIG. 2, the second peripheral area PA2 may include a bending portion.

The display area DA and the first peripheral area PA1 may have a flat state substantially parallel to a plane defined by the first and second directions DR1 and DR2, and the second peripheral area PA1 may be flat. A side of the second peripheral area (PA2) may be extended from a flat state to have a flat state again after passing through a bending portion.

At least a portion of the second peripheral area PA2 may be bent and assembled to be positioned on the rear side of the display area DA.

When assembled, at least a portion of the second peripheral area PA2 overlaps the display area DA on a plane, so the blocking area BA of the display device 1000 may be reduced.

However, the present invention is not limited thereto.

For example, the second peripheral area PA2 may not be bent.

The driving unit 50 may be mounted on the second peripheral area PA2 and may be mounted on the bending unit or located on one of both sides of the bending unit.

The driving unit 50 may be provided in the form of a chip.

The driving unit 50 may be electrically connected to the display area DA to transmit an electrical signal to the display area DA.

For example, the driving unit 50 may provide data signals to the pixels PX disposed in the display area DA.

Alternatively, the driving unit 50 may include a touch driving circuit and may be electrically connected to the touch sensor TS disposed in the display area DA.

Meanwhile, the driving unit 50 may include various circuits in addition to the above-described circuits or may be designed to provide various electrical signals to the display area DA.

Meanwhile, in the display device 1000, a pad part may be positioned at an end of the second peripheral area PA2 and electrically connected to a flexible printed circuit board (FPCB) including a driving chip by the pad part.

Here, the driving chip positioned on the flexible printed circuit board may include various driving circuits for driving the display device 1000 or connectors for supplying power.

According to embodiments, a rigid printed circuit board (PCB) may be used instead of a flexible printed circuit board.

The optical element ES may be disposed below the display panel DP.

The optical element ES may include a first optical element ES1 overlapping the first component area EA1 and a second optical element ES2 overlapping the second component area EA2.

The first optical element ES1 may be an electronic element using light or sound.

For example, the first optical element ES1 may be a sensor that receives and uses light such as an infrared sensor, a sensor that outputs and senses light or sound to measure a distance or recognizes a fingerprint, or a small lamp that outputs light. It may be a speaker or the like that outputs sound.

In the case of an electronic element using light, light of various wavelength bands such as visible light, infrared light, and ultraviolet light can be used.

The second optical element ES2 may include at least one of a camera, an IR camera, a dot projector, an IR illuminator, and a time-of-flight sensor (ToF sensor).

Referring to FIG. 3, the display device 1000 may include a display panel DP, a power supply module PM, a first electronic module EM1, and a second electronic module EM2.

The display panel DP, the power supply module PM, the first electronic module EM1, and the second electronic module EM2 may be electrically connected to each other.

FIG. 3 illustrates a display pixel and a touch sensor TS positioned in the display area DA among the components of the display panel DP.

The power supply module PM may supply power required for overall operation of the display device 1000.

The power supply module (PM) may include a conventional battery module.

The first electronic module EM1 and the second electronic module EM2 may include various functional modules for operating the display device 1000.

The first electronic module EM1 may be directly mounted on a motherboard electrically connected to the display panel DP or may be mounted on a separate board and electrically connected to the motherboard through a connector (not shown).

The first electronic module EM1 may include a control module CM, a wireless communication module TM, an image input module IIM, an audio input module AIM, a memory MM, and an external interface IF.

Some of the modules may not be mounted on the motherboard and may be electrically connected to the motherboard through a flexible printed circuit board connected thereto.

The control module CM may control overall operations of the display device 1000.

The control module (CM) may be a microprocessor.

For example, the control module CM activates or deactivates the display panel DP.

The control module CM may control other modules such as the image input module IIM or the audio input module AIM based on the touch signal received from the display panel DP.

The wireless communication module (TM) can transmit/receive radio signals with other terminals using a Bluetooth or Wi-Fi line.

The wireless communication module (TM) can transmit/receive voice signals using a general communication line.

The wireless communication module TM includes a transmitter TM1 for modulating and transmitting a signal to be transmitted, and a receiver TM2 for demodulating a received signal.

The image input module (IIM) may process the image signal and convert it into image data that can be displayed on the display panel (DP).

The audio input module (AIM) may receive an external sound signal through a microphone in a recording mode, a voice recognition mode, or the like, and convert it into electrical voice data.

The external interface (IF) may serve as an interface connected to an external charger, a wired/wireless data port, a card socket (for example, a memory card, a SIM/UIM card), and the like.

The second electronic module EM2 may include an audio output module (AOM), a light emitting module (LM), a light receiving module (LRM), and a camera module (CMM), and optical elements (ES), some of which may be located on the rear surface of the display panel DP, as shown in FIGS. 1 and 2.

The optical element ES may include a light emitting module LM, a light receiving module LRM, and a camera module CMM.

In addition, the second electronic module EM2 is directly mounted on the motherboard, mounted on a separate board and electrically connected to the display panel DP through a connector (not shown), or connected to the first electronic module EM1.

The audio output module AOM may convert audio data received from the wireless communication module TM or audio data stored in the memory MM, and output the converted audio data to the outside.

The light emitting module LM may generate and output light.

The light emitting module LM may output infrared rays.

For example, the light emitting module LM may include an LED element.

For example, the light receiving module (LRM) may detect infrared rays.

The light receiving module LRM may be activated when infrared rays of a predetermined level or higher are detected.

The light receiving module LRM may include a CMOS sensor.

After the infrared light generated by the light emitting module LM is output, it is reflected by an external subject (for example, a user's finger or face), and the reflected infrared light may be incident to the light receiving module LRM.

The camera module (CMM) may capture an external image.

In one embodiment, the optical element ES may additionally include a light detection sensor or a heat detection sensor.

The optical element ES may detect an external subject received through the front surface or provide a sound signal such as voice to the outside through the front surface.

Also, the optical element ES may include a plurality of elements, and is not limited to one embodiment.

Again, referring to FIG. 2, the housing HM may be coupled to the cover window WU.

The cover window WU may be disposed on the front surface of the housing HM.

The housing HM may be coupled to the cover window WU to provide a predetermined accommodation space.

The display panel DP and the optical element ES may be accommodated in a predetermined accommodating space provided between the housing HM and the cover window WU.

The housing HM may include a material with relatively high rigidity.

For example, the housing HM may include a plurality of frames and/or plates made of glass, plastic, or metal, or a combination thereof.

The housing HM can stably protect components of the display device 1000 accommodated in the inner space from external impact.

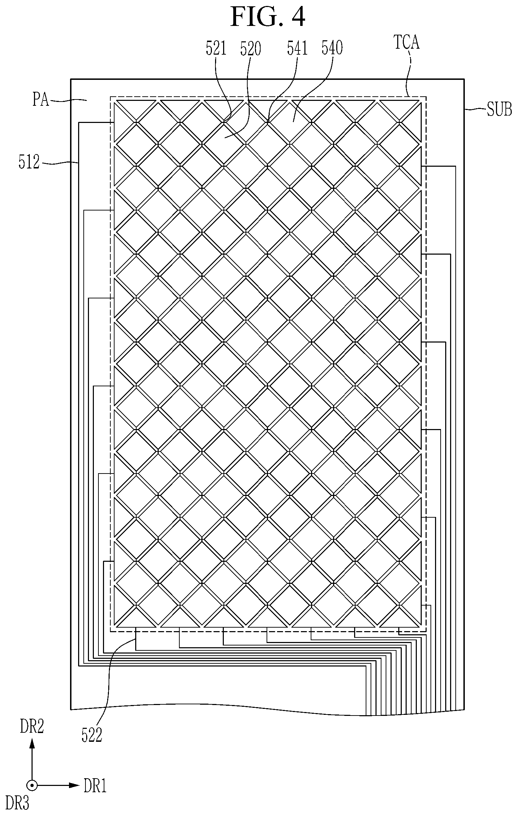

Hereinafter, a sensing electrode according to an embodiment will be described with reference to FIG. 4.

FIG. 4 is a schematic plan view of a sensing electrode in a display panel according to an embodiment.

Referring to FIG. 4, a sensing area TCA including a plurality of sensing electrodes 520 and 540 may be positioned above the display area DA and above the light emitting diode to recognize a touch.

The sensing area TCA may be an area where the touch sensor TS is located.

In the non-display area PA, there may be signal lines or voltage lines (for example, drive voltage lines, low drive voltage lines, etc.) for transmitting signals or voltages to the pixels formed in the display area DA, and a pad part connected to the signal line or voltage line may be located therein.

In addition, a plurality of sensing wires 512 and 522 may be further positioned in the non-display area PA.

The plurality of sensing wires 512 and 522 may be connected to the plurality of sensing electrodes 520 and 540.

The sensing area TCA may include a plurality of sensing electrodes 520 and 540.

The plurality of sensing electrodes 520 and 540 may include a plurality of first sensing electrodes 520 and a plurality of second sensing electrodes 540 electrically separated from each other.

According to embodiments, the plurality of first sensing electrodes 520 may be sensing input electrodes, and the plurality of second sensing electrodes 540 may be sensing output electrodes.

However, it is not limited thereto, and the plurality of first sensing electrodes 520 may be sensing output electrodes, and the plurality of second sensing electrodes 540 may be sensing input electrodes.

The plurality of first sensing electrodes 520 and the plurality of second sensing electrodes 540 may be distributed and arranged in a mesh shape so as not to overlap each other in the sensing area TCA.

The plurality of first sensing electrodes 520 are arranged along one of a column direction and a row direction (refer to FIG. 4, the second direction (DR2)), and the plurality of first sensing electrodes 520 are electrically connected to each other by an first sensing electrode connecting portion 521 (also referred to as a bridge).

Meanwhile, the plurality of second sensing electrodes 540 are also arranged along the other one of the column direction and the row direction (refer to FIG. 4, the first direction DR1), and the plurality of second sensing electrodes 540 are electrically connected to each other through the second sensing electrode connecting portion 541.

The plurality of first sensing electrodes 520 and the plurality of second sensing electrodes 540 may be positioned on the same conductive layer.

According to embodiments, the plurality of first sensing electrodes 520 and the plurality of second sensing electrodes 540 may be positioned on different conductive layers.

Referring to FIG. 4, the first sensing electrode 520 and the second sensing electrode 540 may have a rhombic shape, but are not limited thereto, and may have a polygonal shape such as a quadrangular shape or a hexagonal shape, a circular shape, or an elliptical shape depending on embodiments.

Although the plurality of first sensing electrodes 520 and the plurality of second sensing electrodes 540 are shown as an integral structure of a rhombus, in reality, one rhombic structure has an opening and a structure in which linear structures are arranged in a mesh form.

In this case, the opening may correspond to an area where the light emitting diode emits light upward.

In addition, depending on the embodiment, it may have a shape further including an extension part to improve the sensitivity of the detection sensor.

The first sensing electrode 520 and the second sensing electrode 540 may be formed of a transparent conductor or an opaque conductor.

For example, the first sensing electrode 520 and the second sensing electrode 540 may include transparent conductive oxide (TCO), and the transparent conductive oxide (TCO) may include at least one of indium-tin oxide (ITO), indium-zinc oxide (IZO), zinc oxide (ZnO), carbon nanotube (CNT), and graphene.

Also, the first sensing electrode 520 and the second sensing electrode 540 may have a multilayer structure including two or more metal layers.

For example, the first sensing electrode 520 and the second sensing electrode 540 may have a triple structure in which Ti/Al/Ti are stacked.

Also, the first sensing electrode 520 and the second sensing electrode 540 may include a plurality of openings.

The opening formed in the sensing electrodes 520 and 540 serves to allow light emitted from the light emitting diode to be emitted to the front without interference.

When the first sensing electrode 520 and the second sensing electrode 540 are located on the same layer, one of the first sensing electrode connection part 521 and the second sensing electrode connection part 541 is located on the same layer as the first sensing electrode 520 and the second sensing electrode 540. The other one may be located on a different layer from the first sensing electrode 520 and the second sensing electrode 540.

As a result, the plurality of first sensing electrodes 520 and the plurality of second sensing electrodes 540 may be electrically separated.

The sensing electrode connection part located on another layer may be located on a layer above or below the first sensing electrode 520 and the second sensing electrode 540. The embodiment described below will focus on an embodiment in which the sensing electrode connection part is located in the lower layer, that is, a layer closer to the substrate.

A plurality of sensing wires 512 and 522 connected to the plurality of first sensing electrodes 520 and the plurality of second sensing electrodes 540, respectively, are positioned in the non-display area PA.

Multiple first sensing wires 512 may be connected to a plurality of second sensing electrodes 540 arranged in a first direction DR1, and the plurality of second sensing wires 522 may be connected to the plurality of first sensing electrodes 520 arranged in a second direction DR2.

FIG. 4 illustrates a mutual-cap type sensing unit that senses a touch using two sensing electrodes 520 and 540.

However, depending on embodiments, it may be formed as a self-cap type sensing unit that senses a touch using only one sensing electrode.

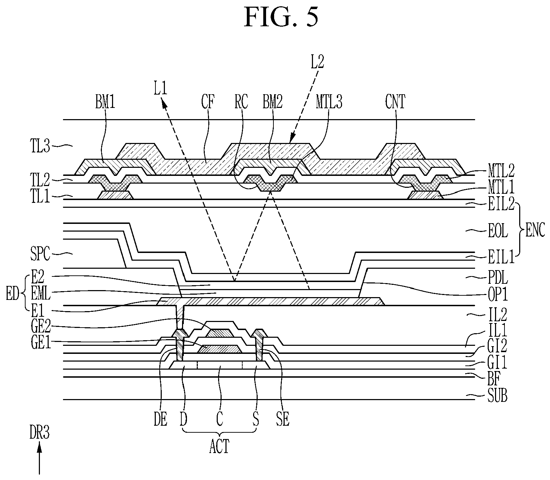

Hereinafter, a display device according to an embodiment will be further described with reference to FIG. 5, focusing on a cross-sectional view in the display area DA.

FIG. 5 is a cross-sectional view illustrating a portion of a display area in a display device according to an embodiment.

Referring to FIG. 5, the substrate SUB may include a rigid material such as glass or a flexible material such as plastic or polyimide.

A buffer layer BF may be further positioned on the substrate SUB to flatten the surface of the substrate SUB and block penetration of impure elements.

The buffer layer BF may include an inorganic material, and may include, for example, an inorganic insulating material such as silicon nitride (SiNx), silicon oxide (SiOx), or silicon nitride oxide (SiOxNy).

Depending on the embodiment, the buffer layer BF may have a single-layer or multi-layer structure including the inorganic insulating material.

A barrier layer (not shown) may be further positioned on the substrate SUB.

In this case, the barrier layer may be positioned between the substrate SUB and the buffer layer BF.

The barrier layer may include an inorganic insulating material such as silicon nitride (SiNx), silicon oxide (SiOx), or silicon nitride oxide (SiOxNy).

The barrier layer (not shown) may have a single-layer or multi-layer structure including the inorganic insulating material.

The semiconductor layer ACT may be positioned on the substrate SUB.

The semiconductor layer ACT may include any one of amorphous silicon, polycrystalline silicon, and an oxide semiconductor.

For example, the semiconductor layer ACT may include low-temperature polysilicon (LTPS) or an oxide semiconductor including at least one of zinc (Zn), indium (In), gallium (Ga), tin (Sn) and their mixtures.

For example, the semiconductor layer ACT may include indium-gallium-zinc oxide (IGZO).

The semiconductor layer ACT may include a channel region C, a source region S, and a drain region D, which are distinguished according to whether or not they are doped with impurities.

The source region S and the drain region D may have conductivity corresponding to those of the conductor.

The first gate insulating layer GI1 may cover the semiconductor layer ACT and the substrate SUB.

The first gate insulating layer GI1 may include an inorganic insulating material such as silicon nitride (SiNx), silicon oxide (SiOx), or silicon nitride oxide (SiOxNy).

The first gate insulating layer GI1 may have a single-layer or multi-layer structure including the above inorganic insulating material.

The gate electrode GE1 may be positioned on the first gate insulating layer GI1.

The gate electrode GE1 may include a metal or metal alloy such as copper (Cu), molybdenum (Mo), aluminum (Al), silver (Ag), chromium (Cr), tantalum (Ta), or titanium (Ti).

The gate electrode GE1 may be a single layer or multiple layers.

A region of the semiconductor layer ACT overlapping the gate electrode GE on a plane may be the channel region C.

A second gate insulating layer GI2 is positioned on the gate electrode GE1.

The second gate insulating layer GI2 may include an inorganic insulating material such as silicon nitride (SiNx), silicon oxide (SiOx), or silicon nitride oxide (SiOxNy).

The second gate insulating layer GI2 may have a single-layer or multi-layer structure including the above inorganic insulating material.

A capacitor electrode GE2 may be positioned on the second gate insulating layer GI2.

The capacitor electrode GE2 may overlap the gate electrode GE1 to form a capacitor.

A first insulating layer IL1 is positioned on the capacitor electrode GE2.

The first insulating layer IL1 may include an inorganic insulating material such as silicon nitride (SiNx), silicon oxide (SiOx), or silicon nitride oxide (SiOxNy).

The first insulating layer IL1 may have a single-layer or multi-layer structure including the above inorganic insulating material.

The source electrode SE and the drain electrode DE may be positioned on the first insulating layer IL1.

The source electrode SE and the drain electrode DE are respectively connected to the source region S and the drain region D of the semiconductor layer ACT by openings formed in the first insulating layer IL1, the second gate insulating layer GI2, and the first gate insulating layer GI1.

Accordingly, the aforementioned semiconductor layer ACT, gate electrode GE, source electrode SE, and drain electrode DE form one transistor.

Depending on the embodiment, the transistor TFT may include only the source and drain regions of the semiconductor layer ACT instead of the source electrode SE and the drain electrode DE.

The source electrode SE and the drain electrode DE are aluminum (Al), copper (Cu), silver (Ag), gold (Au), platinum (Pt), palladium (Pd), nickel (Ni), molybdenum (Mo), tungsten (W), titanium (Ti), chromium (Cr), tantalum (Ta), or another metal or metal alloy.

The source electrode SE and the drain electrode DE may be formed of a single layer or multiple layers.

The source electrode SE and the drain electrode DE according to another embodiment may be composed of a triple layer including an upper layer, an intermediate layer, and a lower layer, and the upper layer and the lower layer may include titanium (Ti), and the intermediate layer may include aluminum (Al).

The second insulating layer IL2 may be positioned on the source electrode SE and the drain electrode DE.

The second insulating layer IL2 covers the source electrode SE and the drain electrode DE.

The second insulating layer IL2 is for planarizing the surface of the substrate SUB having the transistor, it may contain one or more substances and may be an organic insulating film, and is selected from the group consisting of polyimide, polyamide, acrylic resin, benzocyclobutene, and phenol resin.

The first electrode E1 may be positioned on the second insulating layer IL2.

The first electrode E1 is also referred to as an anode electrode, and may be composed of a single layer including a transparent conductive oxide layer or a metal material, or a multi-layer including the same.

The transparent conductive oxide layer may include indium tin oxide (ITO), poly-ITO, indium zinc oxide (IZO), indium gallium zinc oxide (IGZO), and indium tin zinc oxide (ITZO).

The metal material may include silver (Ag), molybdenum (Mo), copper (Cu), gold (Au), and aluminum (Al).

The first electrode E1 may be physically and electrically connected to the drain electrode DE through the opening of the second insulating layer IL2.

Accordingly, the first electrode E1 may receive an output current to be transferred from the drain electrode DE to the light emitting layer EML.

A pixel defining layer PDL and a spacer SPC may be positioned on the first electrode E1 and the second insulating layer IL2.

The pixel defining layer PDL includes a pixel opening OP1 overlapping at least a portion of the first electrode E1.

In this case, the pixel opening OP1 may overlap the center of the first electrode E1 and may not overlap the edge of the first electrode E1.

Accordingly, the size of the opening OP1 may be smaller than that of the first electrode E1.

The pixel defining layer PDL may define a formation position of the light emitting layer EML so that the light emitting layer EML may be positioned on the exposed portion of the upper surface of the first electrode E1.

Each of the pixel defining layer PDL and the spacer SPC may be an organic insulating layer including at least one material selected from the group comprising polyimide, polyamide, acrylic resin, benzocyclobutene, and phenol resin. The pixel definition layer PDL may be formed of a black pixel definition layer (BPDL) containing black pigment.

The light emitting layer EML may be positioned within the pixel opening OP1 partitioned by the pixel defining layer PDL.

The light emitting layer EML may include an organic material emitting red, green, or blue light.

The light emitting layer EML emitting red, green, and blue light may include a low-molecular or high-molecular organic material.

Although the light emitting layer EML is shown as a single layer in FIG. 5, auxiliary layers such as an electron injection layer, an electron transport layer, a hole transport layer, and a hole injection layer may also be included above and below the light emitting layer EML, a hole injection layer and a hole transport layer may be positioned below the EML, and an electron transport layer and an electron injection layer may be positioned above the light emitting layer EML.

The second electrode E2 may be positioned on the pixel defining layer PDL and the light emitting layer EML.

The second electrode E2 may also be referred to as a cathode electrode, and it may include at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but is not limited to these.

In addition, the second electrode E2 may be translucent, and in this case, a micro-cavity may be formed together with the first electrode E1.

According to the micro-cavity structure, light of a specific wavelength is emitted upward due to the spacing and characteristics between both electrodes, and as a result, red, green, or blue colors can be displayed.

The first electrode E1, the light emitting layer EML, and the second electrode E2 may form one light emitting element ED.

The encapsulation layer ENC may be positioned on the second electrode E2.

The encapsulation layer ENC may include at least one inorganic layer and at least one organic layer.

In this embodiment, the encapsulation layer ENC may include a first inorganic encapsulation layer EIL1, an organic encapsulation layer EOL, and a second inorganic encapsulation layer EIL2.

However, this is only an example, and the number of inorganic layers and organic layers constituting the encapsulation layer ENC may be variously changed.

A lower sensing electrode part MTL1 and an upper sensing electrode part MTL2 may be positioned on the encapsulation layer ENC.

Although the present specification has limited the configuration in which the lower sensing electrode part MTL1 is positioned directly on the encapsulation layer ENC, the lower sensing insulating layer is positioned between the encapsulation layer ENC and the lower sensing electrode part MTL1 without being limited thereto.

The lower sensing electrode part MTL1 may include at least one of the aforementioned plurality of sensing electrodes 520 and 540, the first sensing electrode connection part 521, and the second sensing electrode connection part 541.

The upper sensing electrode part MTL2 may include the remains of the plurality of sensing electrodes 520 and 540, the first sensing electrode connection part 521 and the second sensing electrode connection part 541 described above.

For example, the lower sensing electrode part MTL1 includes a plurality of sensing electrodes 520 and 540 and the first sensing electrode connecting part 521, and the upper sensing electrode part MTL2 includes the second sensing electrode connecting part 541.

Alternatively, according to an embodiment, the lower sensing electrode part MTL1 includes the second sensing electrode connection part 541, and the upper sensing electrode part MTL2 includes the plurality of sensing electrodes 520 and 540 and the first sensing electrode connection part 521.

It is not limited thereto, and may be modified in various embodiments.

This specification describes an embodiment in which the lower sensing electrode part MTL1 includes a sensing electrode connecting part.

The first sensing insulating layer TL1 may be positioned on the encapsulation layer ENC and the lower sensing electrode part MTL1.

The first sensing insulating layer TL1 may include an inorganic insulating material or an organic insulating material.

The inorganic insulating material may include at least one of silicon nitride, aluminum nitride, zirconium nitride, titanium nitride, hafnium nitride, tantalum nitride, silicon oxide, aluminum oxide, titanium oxide, tin oxide, cerium oxide, or silicon oxynitride.

The organic insulating material may include at least one of acrylic resin, methacrylic resin, polyisoprene, vinyl resin, epoxy resin, urethane resin, cellulose resin, and perylene resin.

An upper sensing electrode part MTL2 may be positioned on the first sensing insulating layer TL1.

As described above, the upper sensing electrode part MTL2 may include at least one of the plurality of sensing electrodes 520 and 540, the first sensing electrode connection part 521, and the second sensing electrode connection part 541.

The upper sensing electrode part MTL2 according to an embodiment may include a plurality of sensing electrodes 520 and 540, and a first sensing electrode connection part 521.

The upper sensing electrode part MTL2 may be electrically connected to the lower sensing electrode part MTL1 through a contact hole formed in the first sensing insulating layer TL1.

The display device according to an embodiment may further include a reflective layer MTL3 positioned on the same layer as the upper sensing electrode part MTL2.

The reflective layer MTL3 may be formed in the same process as the upper sensing electrode part MTL2 and may include the same material.

The reflective layer MTL3 may be positioned on the first sensing insulating layer TL1.

The reflective layer MTL3 may overlap the light emitting layer EML.

An etching process may be performed in the first sensing insulating layer TL1 to include a contact hole CNT for electrically connecting the lower sensing electrode part MTL1 and the upper sensing electrode part MTL2.

In the etching process, a concave portion RC may be formed in an area overlapping the reflective layer MTL3.

The recessed portion RC may have a shape recessed from the flat upper surface of the first sensing insulating layer TL2 toward the substrate SUB.

The recessed portion RC may be recessed at the same height as the height of the contact hole CNT from the upper surface of the first sensing insulating layer TL2.

The reflective layer MTL3 may have a shape corresponding to that of the first sensing insulating layer TL1 contacting the reflective layer MTL3.

The reflective layer MTL3 may have a concave shape in cross-section along the concave portion RC of the first sensing insulating layer TL2.

A lower surface of the reflective layer MTL3 may have a curved shape along the recessed portion RC.

Alternatively, the lower surface of the reflective layer MTL3 may have a step or an inclined surface according to the shape of the concave portion RC.

The reflective layer MTL3 may cause the light L1 emitted from the light emitting layer EML to be reflected back toward the second electrode E2 from the lower surface of the reflective layer MTL3.

The light L1 reflected toward the second electrode E2 may be reflected from the second electrode E2 toward the outside of the display device.

A second sensing insulating layer TL2 may be positioned on the upper sensing electrode MTL2 and the reflective layer MTL3.

The second sensing insulating layer TL2 may include an inorganic insulating material or an organic insulating material.

The inorganic insulating material may include at least one of silicon nitride, aluminum nitride, zirconium nitride, titanium nitride, hafnium nitride, tantalum nitride, silicon oxide, aluminum oxide, titanium oxide, tin oxide, cerium oxide, or silicon oxynitride.

The organic insulating material may include at least one of acrylic resin, methacrylic resin, polyisoprene, vinyl resin, epoxy resin, urethane resin, cellulose resin, and perylene resin.

Light blocking layers BM1 and BM2, and a color filter CF may be positioned on the second sensing insulating layer TL2.

The light blocking layers BM1 and BM2 according to an embodiment may include a first light blocking layer BM1 and a second light blocking layer BM2.

The first light blocking layer BM1 may be positioned to overlap the lower sensing electrode part MTL1 and the upper sensing electrode part MTL2, or may be positioned to overlap at least a portion of the pixel defining layer PDL, and may be spaced apart from the first electrode E1 without overlapping.

This is to prevent the first electrode E1 and the light emitting layer EML capable of displaying an image from being covered by the first light blocking layer BM1, the lower sensing electrode part MTL1, and the upper sensing electrode part MTL2.

The second light blocking layer BM2 may overlap the reflective layer MTL3.

The second light blocking layer BM2 may completely cover the reflective layer MTL3.

The second light blocking layer BM2 may overlap the first electrode E1 and the light emitting layer EML.

The second light blocking layer BM2 may absorb the external light L2 incident to the light emitting region and reduce reflection of the external light.

The color filter CF may be positioned on the light blocking layers BM1 and BM2, and the second sensing insulating layer TL2.

The color filter CF includes a red color filter that transmits red light, a green color filter that transmits green light, and a blue color filter that transmits blue light.

Each color filter CF may be positioned to overlap the first electrode E1 of the light emitting diode on a plane.

Since light emitted from the light emitting layer EML may be emitted while being changed to a corresponding color while passing through a color filter, all lights emitted from the light emitting layer EML may have the same color.

However, in the light emitting layer EML, light of different colors may be emitted, and a displayed color may be enhanced by allowing light to pass through a color filter of the same color.

The first light blocking layer BM1 may be positioned between each color filter CF.

Depending on the embodiment, the color filter CF may be replaced with a color conversion layer, or a color conversion layer may be further included.

The color conversion layer may include quantum dots.

A planarization layer TL3 covering the color filter CF is positioned on the color filter CF.

The planarization layer TL3 is for planarizing the upper surface of the light emitting display panel, and may be a transparent organic insulating layer containing at least one material selected from the group consisting of polyimide, polyamide, acrylic resin, benzocyclobutene, and phenol resin.

According to embodiments, a low refractive index layer and a planarization layer may be further positioned on the planarization layer TL3 to improve front visibility and light emission efficiency of the display panel.

Light may be emitted while being refracted to the front surface by the low refractive index layer and the planarization layer having high refractive properties.

In this case, depending on the embodiment, the low refractive index layer and the planarization layer may be positioned directly on the color filter CF while the planarization layer TL3 is omitted.

In this embodiment, the polarizing plate is not included on the planarization layer TL3.

The polarizing plate may play a role of preventing display quality from deteriorating while being recognized by a user as external light is incident and reflected from a sidewall of a pixel opening of the first electrode E1 or the pixel defining layer PDL.

However, the polarizing plate not only reduces reflection of external light but also reduces light emitted from the light emitting layer EML, so that more power is consumed to display a certain luminance.

In order to reduce power consumption, the light emitting display device of this embodiment may not include a polarizing plate.

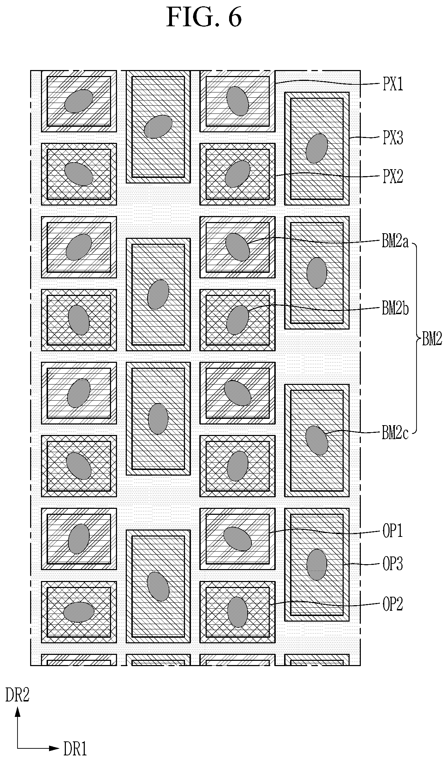

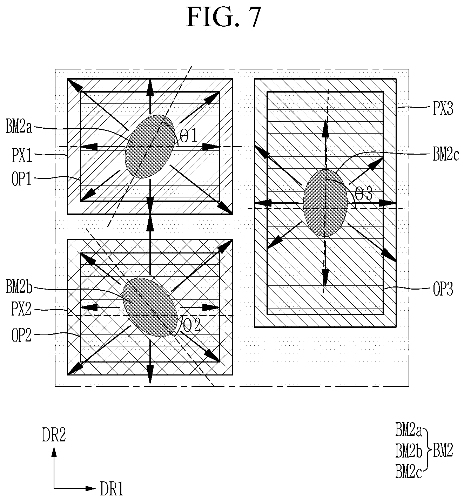

Hereinafter, the shape of the second light blocking layer formed in the display area DA will be described with reference to FIG. 6 and FIG. 7.

FIG. 6 is a schematic plan view illustrating a plurality of pixels according to an embodiment, and FIG. 7 is a plan view showing a portion of FIG. 6.

FIG. 6 and FIG. 7 show the pixel openings OP1, OP2, and OP3 of the pixel defining layer PDL corresponding to the light emitting layers displaying the three primary colors of red, green, and blue and the second light blocking layer BM2.

The display area DA according to an embodiment may include a first pixel PX1 emitting red light, a second pixel PX2 emitting green light, and a third pixel PX3 emitting blue light.

For example, as shown in FIG. 6, the first pixel PX1 and the second pixel PX2 are alternately disposed along the second direction DR2 in one column, and in another column adjacent to the column, the third pixel (PX3) can be repeatedly arranged.

However, it is not limited to this arrangement, and the first pixel PX1, the second pixel PX2, and the third pixel PX3 may be arranged in various forms.

The second light blocking layer BM2 includes a second-1 sub-light blocking layer BM2a overlapping the first pixel PX1, a second-2 sub-light blocking layer BM2b overlapping the second pixel PX2, and a second-3 sub-light blocking layer BM2c overlapping the third pixel PX3.

The second-1 sub-light blocking layer BM2a may overlap the light emitting layer EML emitting red light, and the second-2 sub-light blocking layer BM2b may overlap the light emitting layer EML emitting green light, and the second-3 sub-light blocking layer BM2c may overlap the light emitting layer EML emitting blue light.

The second-1 sub-light blocking layer BM2a, the second-2 sub-light blocking layer BM2b, and the second-3 sub-light blocking layer BM2c have the same oval shape.

The second-1 sub-light blocking layer BM2a, the second-2 sub-light blocking layer BM2b, and the second-3 sub-light blocking layer BM2c have long and short axes of the same length.

Each of the second-1 sub-light blocking layer BM2a, the second-2 sub-light blocking layer BM2b, and the second-3 sub-light blocking layer BM2c has an elliptical planar shape with the same eccentricity.

Each of the second-1 sub-light blocking layer BM2a, the second-2 sub-light blocking layer BM2b, and the second-3 sub-light blocking layer BM2c may have an eccentricity of 0.2 or more and 0.85 or less.

Here, the ellipse has two focal points, may have a shape connecting points where the sum of the distances to the two focal points is constant, and may have a major axis and a minor axis.

On the other hand, the eccentricity of an ellipse is a value obtained by dividing the distance between two focal points by the length of its major axis.

If the eccentricity is 0, it is a circle, and if it is 1, it forms a parabola, so the ellipse has an eccentricity value greater than 0 and less than 1.

The ratio of the major axis to the minor axis of the second-1 sub-light blocking layer BM2a may be 1:1 to 2:1.

When the ratio of the major axis to the minor axis of the second-1 sub-light blocking layer BM2a exceeds 2:1, the reflectance of external light may increase as the area occupied by the second-1 sub-light blocking layer BM2a decreases.

Also, the length of the major axis of the second-1 sub-light blocking layer BM2a may be shorter than the length of the short side of the first pixel PX1.

This serves to rotate the second-1 sub-light blocking layer BM2a at various angles within the first pixel PX1.

The display device according to an embodiment includes a plurality of the second-1 sub-light blocking layers BM2a.

When the angle formed by the major axis of the second-1 sub-light blocking layer BM2a and the first direction DR1 is referred to as the first angle Θ1, the first angle Θ1 may have at least two different angle values.

The first angle Θ1 may have, for example, at least three or more different angle values, at least four or more different angle values, or five or more different angle values.

The plurality of major axes of the plurality of the second-1 sub-light blocking layers BM2a may be variously arranged at irregular intervals or variously arranged at regular intervals.

In an embodiment in which the major axes of the second-1 sub-light blocking layer BM2a are arranged at equal intervals, the arrangement may be intentional to reduce a diffraction pattern or may be arranged at equal intervals due to a process error.

The major axes of the plurality of the second-1 sub-light blocking layers BM2a may be variously arranged at intervals of 90 degrees or less, 60 degrees or less, 45 degrees or less, or 36 degrees or less.

For example, when the angles of the major axes of the second-1 sub-light blocking layer BM2a are formed at intervals of 36 degrees, and one major axis has 0 degrees with respect to the first direction DR1, 36 degrees, 72 degrees, 108 degrees and 144 degrees, it can have a total of 5 angles.

The five angles can be checked by dividing the angle of 180 degrees by 5, which is the number of directions, to determine the distance between the angles of the major axis, so it may be obtained by dividing by the number based on 180 degrees.

The ratio of the major axis to the minor axis of the second-2 sub-light blocking layer BM2b may be 1:1 to 2:1.

When the ratio of the major axis to the minor axis of the second-2 sub-light blocking layer BM2b exceeds 2:1, the reflectance of external light may increase as the area occupied by the second-2 sub-light blocking layer BM2b decreases.

Also, the length of the major axis of the second-2 sub-light blocking layer BM2b may be shorter than the length of the short side of the second pixel PX2.

This serves to rotate the second-2 sub-light blocking layer BM2b at various angles within the second pixel PX2.

The display device according to an embodiment includes a plurality of second-2 sub-light blocking layers BM2b.

When the angle formed by the major axis of the second-2 sub-light blocking layer BM2b and the first direction DR1 is referred to as the second angle Θ2, the second angle Θ2 may have at least two different angle values.

The second angle Θ2 may have, for example, at least three or more different angle values, at least four or more different angle values, or five or more different angle values.

The plurality of major axes of the plurality of the second-2 sub-light blocking layers BM2b may be variously arranged at irregular intervals or variously arranged at regular intervals.

In an embodiment in which the major axes of the second-2 sub-light blocking layers BM2b are arranged at equal intervals, they may be intentionally arranged to reduce a diffraction pattern or may be arranged at equal intervals due to a process error.

The major axes of the plurality of the second-2 sub-light blocking layers BM2b may be variously arranged at intervals of 90 degrees or less, 60 degrees or less, 45 degrees or less, or 36 degrees or less.

For example, when the angles of the major axes of the second-2 sub-light blocking layer BM2b are formed at intervals of 36 degrees, and one major axis has 0 degrees with respect to the first direction DR1, it can have an angle of 36 degrees, 72 degrees, 108 degrees and 144 degrees, so it can have a total of 5 angles.

The five angles can be determined by dividing the 180-degree angle by the number of directions, which is 5, to check the gap between the angles of the major axis, this means that the two angles that have a 180-degree angle out of a 360-degree angle are essentially the same as the direction of the major axis of the ellipse, so it can be calculated by dividing the number based on 180 degrees.

The ratio of the major axis to the minor axis of the second-3 sub-light blocking layer BM2c may be 1:1 to 2:1.

When the ratio of the major axis to the minor axis of the second-3 sub-light blocking layer BM2c exceeds 2:1, the reflectance of external light may increase as the area occupied by the second-3 sub-light blocking layer BM2c decreases.

Also, the length of the major axis of the second-3 sub-light blocking layer BM2c may be shorter than the length of the short side of the third pixel PX3.

This serves to rotate the second-3 sub-light blocking layer BM2c at various angles within the third pixel PX3.

The display device according to an embodiment includes a plurality of second-3 sub-light blocking layers BM2c.

When an angle formed by the major axis of the second-3 sub-light blocking layer BM2c and the first direction DR1 is referred to as a third angle Θ3, the third angle Θ3 may have at least two different angle values.

The third angle Θ3 may have, for example, at least three or more different angle values, at least four or more different angle values, or five or more different angle values.

The plurality of major axes of the plurality of second-3 sub-light blocking layers BM2c may be variously arranged at irregular intervals or variously arranged at regular intervals.

In an embodiment in which the major axes of the second-3 sub-light blocking layers BM2c are arranged at equal intervals, they may be intentionally arranged to reduce a diffraction pattern or may be arranged at equal intervals due to a process error.

The major axes of the second-3 sub-light blocking layers BM2c may be variously arranged at intervals of 90 degrees or less, 60 degrees or less, 45 degrees or less, or 36 degrees or less.

For example, when the angles of the major axes of the second-3 sub-light blocking layer BM2c are formed at intervals of 36 degrees, and one major axis has 0 degrees with respect to the first direction DR1, it can have an angle of 36 degrees, 72 degrees, 108 degrees and 144 degrees, so it can have a total of 5 angles.

The five angles can be determined by dividing the 180-degree angle by the number of directions, which is 5, to check the spacing between the angles of the major axis, this means that the two angles with a 180-degree angle out of the 360-degree angle are essentially the same direction as the major axis of the ellipse, so it can be calculated by dividing by the number based on 180 degrees.

As discussed, the second-1 sub-shading component (BM2a), the second-2 sub-shading component (BM2b), and the second-3 sub-shading component (BM2c) each have an elliptical shape, and the direction in which the major axis of the ellipse is oriented can be randomly arranged.

As shown in FIG. 7, the degree of reflection of external light may vary according to the direction of the major axis of the ellipse of the second light blocking layer BM2.

At this time, as the major axes of the second-1 sub-light blocking layer BM2a, the second-2 sub-light blocking layer BM2b, and the second-3 sub-light blocking layer BM2c are disposed at various angles, uniformity is obtained throughout the display device. It may have an external light reflection property.

Accordingly, external light reflection characteristics such as color separation and diffraction patterns may be improved.

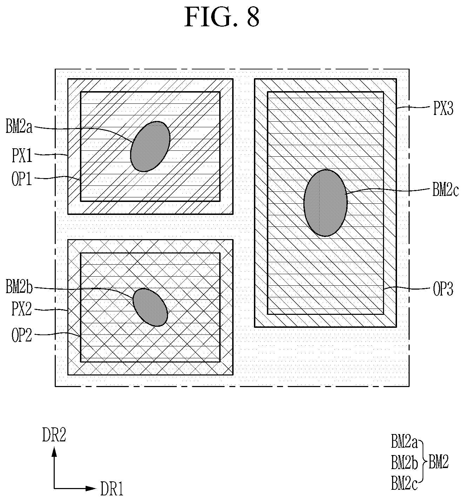

Hereinafter, a display device according to another embodiment will be described with reference to FIG. 8 to FIG. 11.

FIG. 8, FIG. 9, FIG. 10, and FIG. 11 are schematic plan views illustrating a plurality of pixels according to an embodiment.

Referring to FIG. 8, the second-1 sub-light blocking layer BM2a, the second-2 sub-light blocking layer BM2b, and the second-3 sub-light blocking layer BM2c according to an embodiment have elliptical shapes having different sizes.

The second-1 sub-light blocking layer BM2a, the second-2 sub-light blocking layer BM2b, and the second-3 sub-light blocking layer BM2c may have different areas.

The length of the major axis and the minor axis of the second-1 sub-light blocking layer BM2a, the length of the major axis and the minor axis of the second-2 sub-light blocking layer BM2b, and the length of the second-3 sub-light blocking layer BM2c may be different.

In addition, the ratio of the major axis to the minor axis of the second-1 sub-light blocking layer BM2a, the ratio of the major axis to the minor axis of the second-2 sub-light blocking layer BM2b, and the major axis to minor axis of the second-3 sub-light blocking layer BM2c may be different.

Also, depending on embodiments, the eccentricity of the second-1 sub-light blocking layer BM2a, the second-2 sub-light blocking layer BM2b, and second-3 sub-light blocking layer BM2c may be different.

Although the present specification shows an embodiment in which the sizes of the second-3 sub-light blocking layer BM2c, the second-1 sub-light blocking layer BM2a, and the second-2 sub-light blocking layer BM2b decrease in order, it is not limited thereto, and the sizes of the second-3 sub-light blocking layer BM2c, the second-1 sub-light blocking layer BM2a, and the second-2 sub-light blocking layer BM2a may be variously modified.

The degree of reflection of red light, green light, and blue light can vary, and the size of the second-1 sub-light blocking layer (BM2a), the second-2 sub-light blocking layer (BM2b), and the second-3 sub-light blocking layer (BM2c) can be adjusted depending on the degree of external light reflection.

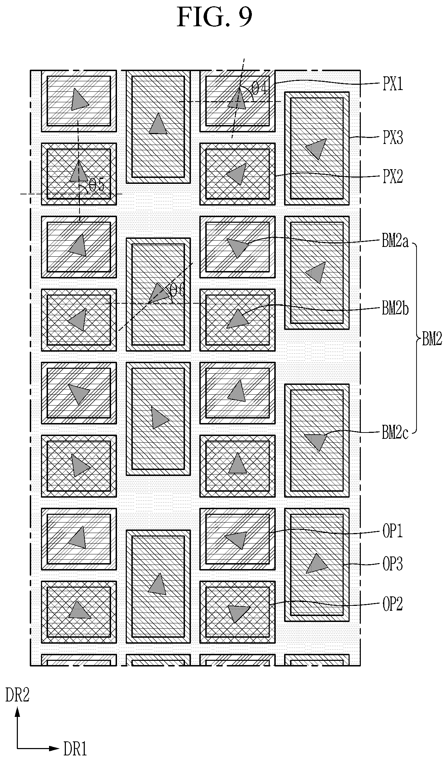

Referring to FIG. 9, each of the second-1 sub-light blocking layer BM2a, second-2 sub-light blocking layer BM2b, and second-3 sub-light blocking layer BM2c may have a triangular shape in planar view.

The second-1 sub-light blocking layer BM2a may be disposed in a random direction within the first pixel PX1.

When an angle formed between a first imaginary line passing through one vertex of the second-1 sub-light blocking layer BM2a and the first direction DR1 is referred to as a fourth angle Θ4, the fourth angle Θ4 may have at least two values.

The second-1 sub-light blocking layer BM2a may be disposed within the first pixel PX1 so that the fourth angle Θ4 has various values.

The second-1 sub-light blocking layer BM2a may be disposed such that the fourth angle Θ4 has equal or unequal intervals.

The second-2 sub-light blocking layer BM2b may be disposed in a random direction within the second pixel PX2.

When an angle formed between a second imaginary line passing through one vertex of the second-2 sub-light blocking layer BM2b and the first direction DR1 is referred to as a fifth angle Θ5, the fifth angle Θ5 may have at least two values.

The second-2 sub-light blocking layer BM2b may be disposed within the second pixel PX2 so that the fifth angle Θ5 has various values.

The second-2 sub-light blocking layer BM2b may be arranged so that the fifth angle Θ5 has equal or unequal intervals.

The second-3 sub-light blocking layer BM2c may be disposed in a random direction within the third pixel PX3.

When an angle formed between a third imaginary line passing through one vertex of the second-3 sub-light blocking layer BM2c and the first direction DR1 is referred to as the sixth angle Θ6, the sixth Θ6 may have at least two values.

The second-3 sub-light blocking layer BM2c may be disposed within the third pixel PX3 so that the sixth angle Θ6 has various values.

The second-3 sub-light blocking layer BM2c may be arranged such that the sixth angle Θ6 has equal or unequal intervals.

The second-1 sub-light blocking layer BM2a, the second-2 sub-light blocking layer BM2b, and the second-3 sub-light blocking layer BM2c may have the same area or different areas according to embodiments.

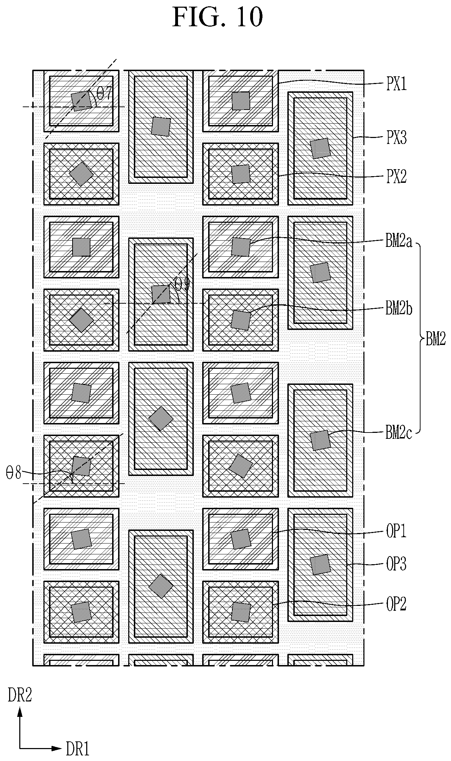

Referring to FIG. 10, each of the second-1 sub-light blocking layer BM2a, the second-2 sub-light blocking layer BM2b, and the second-3 sub-light blocking layer BM2c may have a rectangular shape on a plane.

The second-1 sub-light blocking layer BM2a may be disposed in a random direction within the first pixel PX1.

When an angle formed between a first imaginary line passing through one vertex of the second-1 sub-light blocking layer BM2a and the first direction DR1 is referred to as a fourth angle Θ7, a seventh angle Θ7 may have at least two values.

The second-1 sub-light blocking layer BM2a may be disposed within the first pixel PX1 so that the seventh angle Θ7 has various values.

The second-1 sub-light blocking layer BM2a may be arranged so that the seventh angle Θ7 has equal or unequal intervals.

The second-2 sub-light blocking layer BM2b may be disposed in a random direction within the second pixel PX2.

When an angle formed between a second imaginary line passing through one vertex of the second-2 sub-light blocking layer BM2b and the first direction DR1 is referred to as an eighth angle Θ8, the eighth angle Θ8 may have at least two values.

The second-2 sub-light blocking layer BM2b may be disposed within the second pixel PX2 so that the eighth angle Θ8 has various values.

The second-2 sub-light blocking layer BM2b may be arranged such that the eighth angle Θ8 has equal or unequal intervals.

The second-3 sub-light blocking layer BM2c may be disposed in a random direction within the third pixel PX3.

When an angle formed between an imaginary third line passing through any one vertex of the second-3 sub-light blocking layer BM2c and the first direction DR1 is referred to as a ninth angle Θ9, the ninth angle Θ9 may have at least two values.

The second-3 sub-light blocking layer BM2c may be disposed within the third pixel PX3 so that the ninth angle Θ9 has various values.

The second-3 sub-light blocking layer BM2c may be disposed such that the ninth angle Θ9 has equal or unequal intervals.

Also, the second-1 sub-light blocking layer BM2a, the second-2 sub-light blocking layer BM2b, and the second-3 sub-light blocking layer BM2c may have the same area or different areas depending on embodiments.

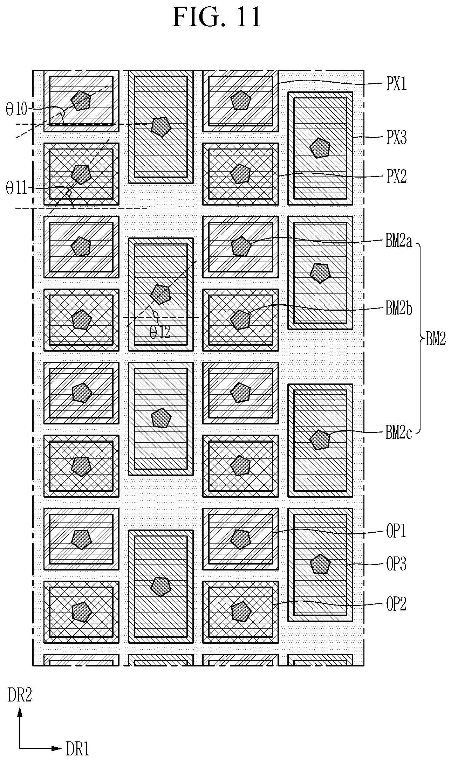

Referring to FIG. 11, each of the second-1 sub-light blocking layer BM2a, the second-2 sub-light blocking layer BM2b, and the second-3 sub-light blocking layer BM2c may have a pentagonal shape in planar view.

The second-1 sub-light blocking layer BM2a may be disposed in a random direction within the first pixel PX1.

When an angle formed between a first imaginary line passing through one vertex of the second-1 sub-light blocking layer BM2a and the first direction DR1 is referred to as a tenth angle Θ10, the tenth angle Θ10 may have at least two values.

The second-1 sub-light blocking layer BM2a may be disposed within the first pixel PX1 so that the tenth angle Θ10 has various values.

The second-1 sub-light blocking layer BM2a may be arranged so that the tenth angle Θ10 has equal or unequal intervals.

The second-2 sub-light blocking layer BM2b may be disposed in a random direction within the second pixel PX2.

When an angle formed between a second imaginary line passing through one vertex of the second-2 sub-light blocking layer BM2b and the first direction DR1 is referred to as an eleventh angle Θ11, the eleventh angle Θ11 may have at least two values.

The second-2 sub-light blocking layer BM2b may be disposed within the second pixel PX2 so that the eleventh angle Θ11 has various values.

The second-2 sub-light blocking layer BM2b may be arranged such that the eleventh angle Θ11 has equal or unequal intervals.

The second-3 sub-light blocking layer BM2c may be disposed in a random direction within the third pixel PX3.

When an angle between a third imaginary line passing through a vertex of the second-3 sub-light blocking layer BM2c and the first direction DR1 is referred to as a twelfth angle Θ12, the twelfth angle Θ12 may have at least two values.

The second-3 sub-light blocking layer BM2c may be disposed within the third pixel PX3 so that the twelfth angle Θ12 has various values.

The second-3 sub-light blocking layer BM2c may be arranged so that the twelfth angle Θ12 has equal or unequal intervals.

Also, the second-1 sub-light blocking layer BM2a, the second-2 sub-light blocking layer BM2b, and the second-3 sub-light blocking layer BM2c may have the same area or different areas depending on embodiments.

Although the embodiments of the present invention have been described in detail above, the scope of the present invention is not limited thereto, and various modifications and improvements made by a person of ordinary skill in the art using the basic concepts of the present invention defined in the following claims are also included in the scope of the present invention.

## Claims

1. A display device, comprising:
a substrate;
a first electrode positioned on the substrate;
a pixel defining layer having a pixel opening overlapping the first electrode;
a light emitting layer positioned within the pixel opening;
a second electrode positioned on the light emitting layer and the pixel defining layer;
an encapsulation layer positioned on the second electrode;
a lower sensing electrode part positioned on the encapsulation layer;
a first sensing insulating layer positioned on the lower sensing electrode part;
an upper sensing electrode part and a reflective layer positioned on the first sensing insulating layer; and
a first light blocking layer and a second light blocking layer disposed on the first sensing insulating layer;
wherein at least a portion of the lower surface of the reflective layer has an inclined surface.

2. The display device of claim 1, wherein:
the second light blocking layer comprises
a second-1 sub-light blocking layer overlapping a first pixel;
a second-2 sub-light blocking layer overlapping a second pixel, and
a second-3 sub-light blocking layer overlapping a third pixel.

3. The display device of claim 2, wherein:
the display device includes a plurality of second-1 sub-light blocking layers;
the second-1 sub-light blocking layer has an elliptical shape and has a first major axis, and
a first angle between the first major axis and the first direction has a value of at least 2 or greater.

4. The display device of claim 3, wherein:
the first major axes of the plurality of second-1 sub-light blocking layers are randomly arranged.

5. The display device of claim 3, wherein:
the plurality of first major axes are disposed at equal intervals.

6. The display device of claim 2, wherein:
the display device includes a plurality of second-2 sub-light blocking layers,
the second-2 sub-light blocking layer has an elliptical shape and has a second major axis, and
a second angle between the second major axis and the first direction has a value greater than or equal to 2.

7. The display device of claim 6, wherein:
the plurality of second major axes are equally spaced or randomly arranged.

8. The display device of claim 2, wherein:
the display device includes a plurality of second-3 sub-light blocking layers;
a second-2 sub-light blocking layer has an elliptical shape and has a third major axis,
a third angle between the third major axis and the first direction has a value of at least 2 or greater.

9. The display device of claim 8, wherein:
the plurality of third major axes are equally spaced or randomly arranged.

10. The display device of claim 2, wherein:
the major axis of the second-1 sub-light blocking layer, the major axis of the second-2 sub-light blocking layer, and the major axis of the second-3 sub-light blocking layer are disposed in different directions.

11. The display device of claim 1, wherein:
the display device further includes a color filter positioned on the first light blocking layer and the second light blocking layer.

12. The display device of claim 2, wherein:
the second-1 sub-light blocking layer, the second-2 sub-light blocking layer, and the second-3 sub-light blocking layer have different areas from each other.

13. The display device of claim 1, wherein:
a planar shape of the second light blocking layer is a triangular, quadrangular or pentagonal.

14. The display device of claim 1, wherein:
the second light blocking layer overlaps the light emitting layer; and
the first light blocking layer overlaps the pixel defining layer.

15. A display device, comprising:
a substrate;
a plurality of first electrodes positioned on the substrate;
a pixel defining layer having a plurality of pixel openings overlapping each of the plurality of first electrodes;
a plurality of light emitting layers respectively positioned within the plurality of pixel openings of the pixel defining layer;
a second electrode positioned on the plurality of light emitting layers and the pixel defining layer;
an encapsulation layer positioned on the second electrode;
a lower sensing electrode part positioned on the encapsulation layer;
a first sensing insulating layer positioned on the lower sensing electrode part;
an upper sensing electrode part positioned on the first sensing insulating layer;
a plurality of reflective layers disposed on the first sensing insulating layer and overlapping the plurality of pixel openings, respectively; and
a plurality of light blocking layers disposed on the plurality of reflective layers,
wherein the plurality of light blocking layers have at least two planar shapes different from each other.

16. The display device of claim 15, wherein:
the second light blocking layer comprises
a second-1 sub-light blocking layer overlapping the first pixel,
a second-2 sub-light blocking layer overlapping the second pixel, and
a second-3 sub-light blocking layer overlapping a third pixel.

17. The display device of claim 16, wherein:
the second-1 sub-light blocking layer has a shape obtained by rotating the second-2 sub-light blocking layer in a clockwise direction on a plane.

18. The display device of claim 16, wherein:
the second-1 sub-light blocking layer and the second-2 sub-light blocking layer have different planar areas.

19. The display device of claim 15, wherein:
the first sensing insulating layer includes a first opening exposing the lower sensing electrode part and a plurality of second openings respectively overlapping the plurality of pixel openings.

20. The display device of claim 19, wherein:
the upper sensing electrode part is formed in the first opening, and
the plurality of reflective layers are formed in the plurality of second openings.
